**Europäisches Patentamt**

**European Patent Office**

**Office européen des brevets**

(19)

(11) Veröffentlichungsnummer: **0 392 151**
**A2**

## (12) EUROPÄISCHE PATENTANMELDUNG

(21) Anmeldenummer: **90102546.0**

(22) Anmeldetag: **09.02.90**

(51) Int. Cl.⁵: **H05K 3/20, H05K 3/10**

(30) Priorität: **13.03.89 DE 3908097**

(43) Veröffentlichungstag der Anmeldung:
**17.10.90 Patentblatt 90/42**

(84) Benannte Vertragsstaaten:
**CH DE ES FR GB IT LI**

(71) Anmelder: **IVO IRION & VOSSELER GMBH & CO.**
**Dauchinger Strasse 58-62**
**D-7730 Villingen-Schwenningen(DE)**

(72) Erfinder: **Haller, Andreas, Ing.grad**
**Herweghstrasse 5**
**D-7730 VS-Schwenningen(DE)**

Erfinder: **Bauser, Herbert, Dr.**
**Bärenseestrasse 8**
**D-7000 Stuttgart 80(DE)**
Erfinder: **Schindler, Bernd, Dr.**
**Arnimstrasse 31**
**D-7000 Stuttgart 1(DE)**
Erfinder: **Kurz, Edmund**
**Neue Stuttgarter Strasse 30**
**D-7037 Magstadt(DE)**

(74) Vertreter: **Patentanwälte Dipl.-Ing. Klaus Westphal Dr. rer. nat. Bernd Mussgnug Dr. rer.nat. Otto Buchner**
**Waldstrasse 33**
**D-7730 VS-Villingen-Schwenningen(DE)**

(54) **Prägefolie zum Aufbringen von Leiterbahnen auf feste oder plastische Unterlagen.**

(57) Die Verbindungsprägefolie besteht im wesentlichen aus einer elektrisch leitenden Schicht (1), die mittels einer Trennschicht (4') an einem Trägerband (5) vorgesehen ist. Die elektrisch leitende Schicht (1) weist auf ihrer dem Trägerband (5) gegenüberliegenden Seite eine Haftschicht (2') auf. Haft-und Trennschichten (2', 4') bestehen im wesentlichen aus Klebstoff (7'). In dieses Klebstoffmaterial (7') sind Lötpulverteilchen (3') dispergiert. Wird eine derartige Verbindungsprägefolie mittels eines Prägestempels bei Erwärmen unter Druck gesetzt, so stellen die elektrisch leitenden Lötpulverteilchen (3') im Bereich der Prägung mit der Unterlage (6) oder einem anstelle des Trägerbandes (5) vorgesehenen Leiter eine elektrisch leitende Verbindung her. Mittels einer derartigen Prägefolie lassen sich folglich in einem einzigen Prägeverfahren elektrische Verbindungen zwischen Leiterbahnen und anderen elektrischen Bauelementen herstellen.

FIG.3

## Prägefolie zum Aufbringen von Leiterbahnen auf feste oder plastische Unterlagen

Die Erfindung betrifft eine Prägefolie der im Oberbegriff des Hauptanspruchs angegebenen Art.

Sie geht hierbei von einer Prägefolie aus, wie sie im einzelnen in der EP 63 347 B1 beschrieben ist.

Prägefolien dieser Art dienen der Herstellung elektrischer oder elektronischer Schaltkreise oder auch der Herstellung elektrischer Bauelemente. Hierbei wird aus einer das Leitermaterial bildenden Metallfolie mittels eines Prägewerkzeuges ein der Schaltung entsprechendes Muster ausgestanzt und auf eine elektrisch isolierende Unterlage aufgeprägt. In bei gedruckten Schaltungen üblicher Weise können die derart geprägten Leiterbahnen mit diskreten Bauelementen bestückt werden. Üblicherweise werden die Bauelemente mit ihren Anschlußkontakten oder auch nachträgliche Verbindungselemente durch Löten mit den Leiterbahnen verbunden.

Die Herstellung derartiger Verbindungen stellt einen weiteren zusätzlichen Arbeitsschritt dar, der wesentlich arbeitsintensiver und zeitraubender als die Herstellung der gesamten Schaltung nach dem Heißprägeverfahren sein kann.

Der Erfindung liegt die Aufgabe zugrunde, eine Prägefolie zu schaffen, mittels welcher zwischen Leiterbahnen untereinander oder zwischen Leiterbahnen und Bauelementen elektrisch leitende Verbindungen in einer dem Heißprägeverfahren nach der oben genannten Druckschrift verfahrenskonformen Technik unter Einsparung zusätzlicher Arbeitsschritte ermöglicht wird.

Gelöst wird diese Aufgabe mit der gemäß Anspruch 1 gekennzeichneten Prägefolie, die nachstehend als Verbindungsprägefolie bezeichnet ist. Sie ermöglicht die elektrische Verbindung der Leiter untereinander sowie der Bauelemente mit den Leitern unmittelbar beim Heißprägeverfahren.

Die Verbindungsprägefolie hat grundsätzlich den gleichen Aufbau wie die Prägefolie nach der EP 63 347 B1. Sie besteht aus einer Haftschicht, einer elektrisch leitenden Schicht, einer Trennschicht und einem Trägerband. Mit Hilfe eines Prägestempels können Leiterbahnen unter Aktivierung von Trennschicht und Haftschicht auf eine feste oder plastische Unterlage geprägt werden.

Nach dem erfindungsgemäßen Vorschlag enthält jedoch mindestens eine der beiden an die elektrisch leitende Schicht angrenzenden Schichten, also die Haftschicht bzw. die Trennschicht, elektrisch leitfähige Substanzen, wie diese im Kennzeichen des Hauptanspruchs im einzelnen definiert sind.

Diese Substanzen, z.B. gemäß Anspruch 2 Lot, ermöglichen es, daß beim Prägen unmittelbar eine Lötverbindung zwischen der Verbindungsprägefolie und einer anderen Leiterbahn oder einem anderen Bauelement hergestellt wird. Wird z.B. eine geprägte Leiterbahn eine Verbindungsfolie mit einer Lot enthaltenden Schicht überprägt, so wird die Verbindungsprägefolie mittels der Klebstoffkomponente in der Haftschicht auf dem Kunststoffsubstrat eine festhaftende Leiterbahn darstellen, die an der Kreuzungsstelle infolge der Lotkomponente eine Lötverbindung mit der darunter liegenden Leiterbahn eingeht. Begünstigt wird diese Verbindung noch dadurch, wenn auch die geprägte Leiterbahn eine Lot enthaltende Trennschicht aufweist.

Wie mit den Ansprüchen 3 und 4 vorgeschlagen ist, kann die Haft- und/oder Trennschicht aus abwechselnd angeordneten Teilflächen mit einem der mechanischen Verbindung dienenden Klebemittel bzw. mit elektrisch leitfähigen Substanzen, insbesondere Lot, zur Herstellung der elektrischen Verbindung bestehen.

Eine derartige Verteilung ist mit dem Herstellungsverfahren gemäß Anspruch 16 erreichbar. Wird der Klebstoff auf die elektrisch leitende Schicht mittels einer Rändelwalze oder durch Siebdruckbeschichtung bzw. mittels Spritzen durch ein Sieb aufgetragen, so lassen sich Abmessungen gemäß Anspruch 5 realisieren.

Bei diesen Verfahren sind nach Aufbringen der Klebstoffteilflächen auf die zwischen den Teilflächen gelegenen Restflächen in einem Galvanikbad eine die elektrisch leitfähigen Substanzen enthaltende Schicht, vorzugsweise eine Lotschicht, abzuscheiden.

Außer inselförmigem Klebstoffauftrag ist auch ein streifen-oder gitterförmiger Auftrag (Anspruch 6) möglich, der zweckmäßigerweise mittels eines Düsenrohres erzeugbar ist, das aneinandergereihte Austrittsdüsen besitzt.

Als Klebstoff für die Haftschicht eignet sich ein Schmelzkleber gemäß Anspruch 7, wie er im übrigen in der EP 63 347 B1 beschrieben ist. Ein derartiger Klebstoff kann z.B. aus Nitrilkautschuk oder einer wässrigen Klebstoffdispersion, beispielsweise einer 50 prozentigen Dispersion von Acrylat mit Thixotropierungsmittel (z.B. 1 % bis 5 % Acrosil 200 bezogen auf den Feststoffgehalt der Dispersion) bestehen.

Die elektrisch leitfähigen Substanzen enthaltende Schicht kann aus einem Blei-Zinn-Galvanikbad bei folgenden Konditionen abgeschieden werden:
Stromdichte: 1,5 bis 4 A/dm²
Spannung : 0,5 bis 3 Volt
Dicke der Lot- (und Klebstoff-) Schicht: 3 bis 5 μm

Bei einer derartigen Schicht wird eine Kleblötverbindung durch Prägen bei 220 bis 270 °C und einer Prägedauer von 1 bis 3 Sekunden hergestellt.

Die Qualität der Lötverbindung kann entscheidend durch ein der Klebstoffkomponenten beigemengtes Flußmittel verbessert werden, wie mit den Ansprüchen 9 und 11 angegeben ist. Geeignete Flußmittel bestehen aus einer Harzkomponente und aus einem Aktivator nach DIN FSW 22 oder FSW 26. Als Harzkomponente ist auch das bei üblichen Flußmitteln verwendete Kolophonium oder ein modifiziertes Naturharz, z.B. VP 5000/130 der Fa. Liton Kester, geeignet (Anspruch 13). Mit Anspruch 13 sind verschiedene Carbonsäuren als Aktivatoren vorgeschlagen. Grundsätzlich sind als Aktivatoren organische Säuren mit Carboxyl-Hydroxyl-und Aminogruppen (vgl. Anspruch 13) brauchbar.

Bei Verwendung von Kolophonium und Adipinsäure haben sich Mischungsverhältnisse zwischen 1:1 bis 1:4 als zweckmäßig erwiesen.

Nach einem weiteren Vorschlag der Erfindung kann das Lötpulver in der Haftschicht und/oder der Trennschicht dispergiert sein (Anspruch 10). Hierfür ist ein Lötpulver mit Teilchendurchmesser bis zu ca. 20 μm bei einer Konzentration von 90 Gew.-% bei einem Blei-Zinn Lot geeignet.

Ferner können nach einem weiteren Vorschlag Haftschicht und/oder Trennschicht aus einer Mischung von mikroverkapseltem Klebstoff und flußmittelbeschichtetem Lötpulver aufgebaut sein. In diesem Fall verwendet man zum Beispiel einen Zweikomponenten-Epoxid-klebstoff, dessen Komponenten jeweils gesondert verkapselt sind (Anspruch 8).

Das der erfindungsgemäßen Verbindungsfolie zugrundeliegende Prinzip, nach welchem Haft- und/oder Trennschicht aus wenigstens zwei Komponenten, nämlich Klebstoff und Lot, aufgebaut ist, kann auch in der mit Anspruch 15 angegebenen Weise verwirklicht sein. Nach diesem Vorschlag wird die elektrisch leitende Schicht mit einer Blei-Zinn-Schicht, z.B. durch galvanische Verzinnung, versehen, deren äußere Oberfläche beispielsweise bei einer Rauhtiefe von ca. 1,5 μm aufgerauht wird. In die derart hergestellten Vertiefungen wird der Klebstoff eingebracht.

Die in die Trenn- und/oder Haftschicht eingebrachten elektrisch leitfähigen Substanzen müssen nicht wie ein Lot selbst der mechanischen Verbindung dienen. Vielmehr können sie auch aus einem Material, z.B. aus in die Trenn- und/oder Haftschicht dispergierten Pulvermetallen, vorzugsweise Silberpulver, bestehen. Dieses Material dient ausschließlich der elektrischen Verbindung, während die mechanische Verbindung durch den Klebstoff der Haft- und/oder Trennschicht bewirkt wird (Anspruch 14).

Die erfindungsgemäße Verbindungsprägefolie läßt sich in vielfacher Weise einsetzen, wie mit den Ansprüchen 17, 18 und 19 angegeben ist.

Zum einen kann mit der Verbindungsprägefolie die Verbindung zwischen zwei oder mehreren Leiterbahnen einer vorhandenen Schaltung hergestellt werden. Damit ist die erfindungsgemäße Verbindungsprägefolie bevorzugt für die Multilayertechnik geeignet. Wie mit Anspruch 17 angegeben, kann in diesem Fall auf eine schon geprägte Leiterplatte eine isolierende Schicht, z.B. in Form einer Folie oder eines Decklackes, aufgebracht werden, wobei die Schicht an bestimmten Stellen über den Leiterbahnen ausgespart ist. Beim Aufprägen eines zweiten Leiterbildes auf die isolierende Schicht mittels einer Verbindungsprägefolie wird an den ausgesparten Stellen eine leitende Verbindung erzeugt.

Nach dem gleichen Verfahren können Kondensatoren hergestellt werden (Anspruch 18). Hierbei wird auf eine geprägte Leiterbahn eine dielektrische Schicht aufgebracht worauf durch Überprägen mit der erfindungsgemäßen Verbindungsprägefolie die elektrischen Anschlüsse an das zunächst geprägte Leiterbild hergestellt werden.

In gleicher Weise können auch flache Bauelemente, z.B. geprägte oder durch Niedertemperatur-Dickschichttechnik aufgebrachte Widerstandsbahnen, mit den Leiterbahnen verbunden werden.

In besonders vorteilhafter Weise lassen sich die erfindungsgemäßen Verbindungsprägefolien mit der SMD-Technik (Surface-mounted-Devices) kombinieren, wie mit Anspruch 19 angegeben ist. Hierbei werden als Unterlage (Substrat) für die Leiterbahnen dienende Kunststoffteile vor dem Aufbringen der Präge folie mit SMD-Bauteilen bestückt, welche in für diese ausgesparte Vertiefungen oder Löcher des Substrates eingesetzt werden. Diese Vertiefungen oder Löcher können zweckmäßigerweise bereits bei der Herstellung, z.B. beim Spritzen, der Kunststoffteile erzeugt werden. Die Dimensionierung dieser Vertiefungen muß derart sein, daß die Kontaktierungsstellen der SMD-Bauteile etwa in der Ebene der Substratsoberfläche gelegen sind. Beim Aufbringen des Leiterbildes mittels der erfindungsgemäßen Verbindungsprägefolie werden dann im gleichen Arbeitsschritt die Lötverbindungen sowie die elektrisch leitenden Klebeverbindungen hergestellt. Damit kann man in drei Arbeitsschritten, nämlich dem Herstellen des Substrates im Kunststoffspritzverfahren, dem Bestücken des Substrates mit SMD-Bauteilen und dem Aufprägen der Leiterbahnen, eine vollständige Schaltung auf einem Kunststoffbauteil herstellen, das daneben auch andere Funktionen erfüllen kann, beispielsweise Gehäuseteil oder Gestell eines Gerätes sein kann.

Nicht zuletzt können mit erfindungsgemäß ausgebildeten Verbindungsprägefolien vorverzinnte Leiterbahnen hergestellt werden, mit welchen das konventionelle Bestücken mit diskreten Bauelementen erheblich erleichtert wird.

Der grundsätzliche Aufbau der erfindungsgemäßen Verbindungsprägefolie ist nachstehend anhand von in der Zeichnung dargestellten Ausführungsbeispielen erläutert. In dieser zeigen:

Figur 1 Schnitt der Verbindungsprägefolie in vergrößerter, nicht maßstabgetreuer Darstellung nach einem ersten Ausführungsbeispiel,

Figur 2 Aufsicht der Trenn- und Haftschicht in vergrößerter Darstellung und

Figur 3 Schnitt der Verbindungsprägefolie nach einem zweiten Ausführungsbeispiel der Erfindung.

Die erfindungsgemäße Verbindungsprägefolie ist grundsätzlich in der gleichen Weise aufgebaut wie die Prägefolie nach der EP 63 347 B1.

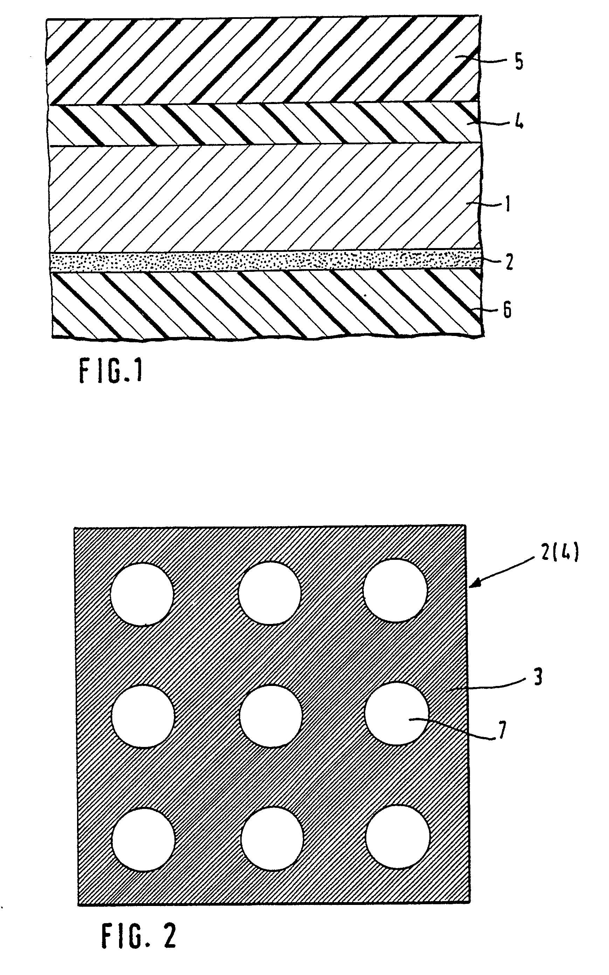

Wie Figur 1 zeigt, ist die elektrisch leitende Schicht 1 auf der einen Seite mit einer Haftschicht 2 und auf der anderen Seite mit einer Trennschicht 4 versehen und wird von einem Trägerband 5 getragen. Die aus den Schichten 1 bis 5 bestehende Verbindungsprägefolie wird bestimmungsgemäß auf eine Unterlage 6 aufgebracht, welche die zu verbindenden Leiterbahnen oder elektrischen Bauelemente trägt.

Haftschicht 2 bzw. Trennschicht 4 sind, wie mit Figur 2 veranschaulicht, im wesentlichen aus einer Lotschicht 3 gebildet, in welche haftvermittelnde Substanzen 7 inselförmig eingebettet sind. Diese Substanzen 7 bestehen aus den eingangs beschriebenen Konstituenten der Trenn- bzw. Haftschicht. Bei dem in Figur 2 dargestellten Muster haben die Haftschichtscheiben 7 einen Durchmesser zwischen 10 μm bis 500 μm und einen Mittenabstand zwischen 20 μm bis 1000 μm.

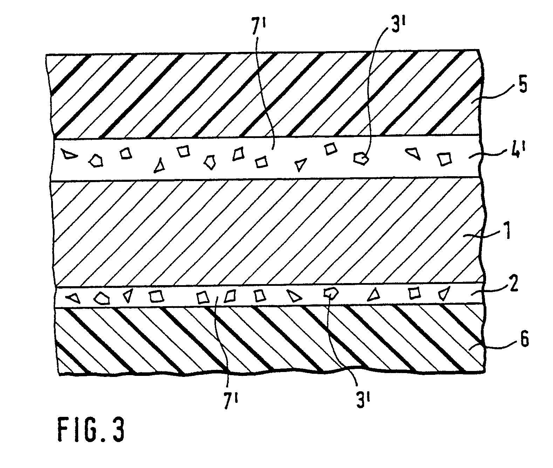

Bei dem zweiten Ausführungsbeispiel gemäß Figur 3 sind in Haft- und Trennschicht $2'$ bzw. $4'$, die selbst aus Klebstoffkomponenten $7'$ bestehen, Lötpulverteilchen $3'$ dispergiert. Bei einer derartigen Ausbildung ist Lötpulver mit einem Teilchendurchmesser bis ca. 20 μm bei einer Konzentration von 90 Gew.% eines Blei-Zinn-Lotes geeignet.

**Ansprüche**

1. Prägefolie zum Aufbringen von Leiterbahnen auf feste oder plastische Unterlagen, welche mindestens aus einer Haftschicht, einer elektrisch leitenden Schicht, welche vorzugsweise aus einem Material gebildet ist, dessen Scherfestigkeit einen so kleinen Wert hat, daß die geprägten Leiterbahnen unter scharfrandiger Trennung von dem nichtgeprägten Teil der leitenden Schicht abreißbar sind, einer Trennschicht und einem Trägerband besteht und aus welcher mit Hilfe eines Prägestempels die Leiterbahnen unter Aktivierung von Trennschicht und Haftschicht prägbar sind, dadurch gekennzeichnet, daß die Trennschicht und/oder die Haftschicht elektrisch leitfähige Substanzen enthält, welche beim Aufbringen der durch Wärme-und/oder Druckeinwirkung aktivierten Prägefolie auf einer mit elektrischen Leitern, Kontakten oder dgl. elektrisch leitenden Elemente versehenen Unterlage mit diesen Elementen elektrisch verbindbar sind.

2. Prägefolie nach Anspruch 1, dadurch gekennzeichnet, daß die elekrisch leitfähige Substanz ein Lot, vorzugsweise ein Blei-/Zinn-Gemisch, ist.

3. Prägefolie nach Anspruch 1 oder 2, dadurch gekennzeichnet, daß die Haft- und/oder die Trennschicht aus im Abstand voneinander vorgesehenen Teilflächen mit einem Kleber zur Herstellung der mechanischen Verbindung mit dem nicht mit elektrisch leitenden Elementen versehenen Teil der Unterlage besteht, zwischen welchen Flächen mit elektrisch leitfähigen Substanzen, insbesondere Lot, zur Herstellung der elektrischen Verbindung mit den elektrisch leitenden Elementen vorgesehen sind.

4. Prägefolie nach Anspruch 3, dadurch gekennzeichnet, daß die den Kleber enthaltenen Teilflächen inselförmig ausgebildet sind.

5. Prägefolie nach Anspruch 4, dadurch gekennzeichnet, daß die inselförmigen Teilflächen im wesentlichen kreisförmig mit einem Durchmesser von 40 μm bis 50 μm sind und einen Mittenabstand von 80 bis 1000 μm voneinander haben.

6. Prägefolie nach Anspruch 3, gekennzeichnet durch streifen-oder gitterförmige Teilflächen.

7. Prägefolie nach einem der Ansprüche 1 bis 6, dadurch gekennzeichnet, daß der Kleber ein Schmelzkleber ist.

8. Prägefolie nach einem der Ansprüche 1 bis 7, dadurch gekennzeichnet, daß der Kleber oder die Kleberkomponenten in Mikrokapseln aufgebracht ist bzw. sind.

9 .Prägefolie nach einem der Ansprüche 1 bis 8, dadurch gekennzeichnet, daß das Lot von Flußmittel umgeben ist.

10. Prägefolie nach einem der Ansprüche 1 bis 8, dadurch gekennzeichnet, daß das Lot in der Haftschicht und/oder der Trennschicht dispergiert ist.

11. Prägefolie nach Anspruch 10, dadurch gekennzeichnet, daß die Trennschicht ein Flußmittel enthält.

12. Prägefolie nach Anspruch 9, 10 oder 11, dadurch gekennzeichnet, daß das Flußmittel aus einer Harzkomponente (Kolophonium) und mindestens einer Carbonsäure besteht.

13. Prägefolie nach Anspruch 12, dadurch gekennzeichnet, daß die Carbonsäure eine Adipinsäure, Zitronensäure, Bernsteinsäure oder Glutaminsäure bzw. ein Glutaminsäurehydrochlorid ist.

14. Prägefolie nach Anspruch 1, dadurch gekennzeichnet, daß die leitenden Komponenten aus in die Haftschicht und/oder die Trennschicht dispergiertem Pulvermetall, vorzugsweise Silber, bestehen.

15. Prägefolie nach einem der Ansprüche 1 bis 3, dadurch gekennzeichnet, daß auf die elektrisch leitende Schicht vorzugsweise durch Galvanisieren eine rauhe Blei-Zinn-Schicht aufgebracht ist, in deren Vertiefungen Klebstoff angebracht ist.

16. Verfahren zur Herstellung der Prägefolie nach einem der Ansprüche 4 bis 6, dadurch gekennzeichnet, daß auf eine elektrisch leitende Folie mittels einer Rändelwalze, mittels Siebdruck-Beschichtung oder mittels Spritzen durch ein Sieb bzw. ein Düsenrohr Klebstoff in Form von Teilflächen aufgetragen wird, worauf auf die zwischen den Teilflächen gelegenen Restflächen in einem Galvanikbad eine die elektrisch leitfähigen Substanzen enthaltene Schicht, vorzugsweise eine Lotschicht, abgeschieden wird.

17. Schaltungsanordnung, bestehend aus mindestens einer Lei terplatte, dadurch gekennzeichnet, daß auf die Leiterplatte eine elektrisch isolierte Schicht, insbesondere eine Folie oder eine Lackschicht, aufgebracht ist, welche an Kontaktstellen Aussparungen aufweist, und daß die isolierende Schicht mittels einer Prägefolie nach einem der Ansprüche 1 bis 15 derart abgedeckt ist, daß diese an den Kontaktstellen eine elektrisch leitende Verbindung herstellt.

18. Kondensator, bestehend aus mehreren metallischen Leitern mit zwischen diesen befindlichen dielektrischen Schichten, dadurch gekennzeichnet, daß die metallischen Leiter mittels einer oder mehrerer Prägefolien nach einem der Ansprüche 1 bis 15 verbunden sind.

19. Schaltungsanordnung mit SMD-Bauteilen, welche in Vertiefungen einer elektrisch isolierenden Trägerplatte oder dergleichen eingelassen sind und mit elektrischen Anschlüssen auf der Oberfläche der Trägerplatte aufliegen, dadurch gekennzeichnet, daß die Trägerplatte mit dem SMD-Bauteilen von einer Prägefolie nach einem der Ansprüche 1 bis 15 überdeckt ist, welche der elektrischen Verbindung der Bauteile dient.

FIG.1

5
4
1
2
6

FIG. 2

2(4)
3
7

FIG. 3